# EUROPEAN PATENT SPECIFICATION

(11) **EP 1 297 564 B1**
(45) Date of publication and mention of the grant of the patent: **17.09.2008**
(21) Application number: 01956164.6
(22) Date of filing: 05.07.2001
(51) Int. Cl.: H01L 21/311

(54) **PROCESS FOR SELECTIVELY ETCHING DOPED SILICON DIOXIDE OVER UNDOPED SILICON DIOXIDE**
VERFAHREN ZUR SELEKTIVEN ÄTZUNG VON DOTIERTEM SILIZIUMOXID AUF UNDOTIERTEM SILIZIUMOXID
PROCEDE D'ATTAQUE SELECTIVE DE DIOXYDE DE SILICIUM DOPE SUR DU DIOXYDE DE SILICIUM NON DOPES

(30) Priority: 05.07.2000 US 610049
(43) Date of publication of application: 02.04.2003
(73) Proprietor: Micron Technology, Inc., Boise, ID 83707-0006 (US)
(72) Inventor: KO, Kei-Yu, Manassas, Virginia 20109 (US); LI, Li, Boise, Idabo 83716 (US); BLALOCK, Guy, T., Eagle, ID 83616 (US)
(74) Representative: Altenburg, Udo
(86) International application number: PCT/US2001/041275
(87) International publication number: WO 2002/003439

(56) References cited:
- EP-A- 0 721 205
- WO-A-98/49719
- US-A- 4 529 476
- US-A- 5 814 563
- US-A- 6 018 184
- US-A- 6 066 555
- US-A- 6 117 791
- PATENT ABSTRACTS OF JAPAN vol. 011, no. 099 (E-493), 27 March 1987 (1987-03-27) & JP 61 251138 A (MATSUSHITA ELECTRIC IND CO LTD), 8 November 1986 (1986-11-08)

## Description

### TECHNICAL FIELD

The present invention relates to processes for selectively etching doped silicon dioxide that overlies undoped silicon dioxide. Particularly, the process of the present invention includes an etchant mixture which includes the use of an ethane gas having the general formula C₂HₓF_{y}, where x is an integer from three to five, inclusive, y is an integer from one to three, inclusive, and x plus y equals six.

### BACKGROUND ART

The fabrication of multi-layered structures upon semiconductor devices typically involves the patterning of doped silicon dioxide layers, including, without limitation, layers of phosphosilicate glass (PSG), borosilicate glass (BSG) and borophosphosilicate glass (BPSG). Such materials are typically employed as passivation layers on semiconductor devices. Etching techniques are typically employed to pattern many types of semiconductor device structures, including the formation of contact openings through passivation layers. Etch stop layers are typically formed on underlying structures, such as over a conductively doped contact region formed in a semiconductor substrate, in order to terminate the etch process once the desired patterning of the passivation layer, or etch substrate, has occurred. Silicon nitride (Si₃N₄) is typically utilized was an etch stop during the patterning of silicon dioxide.

Conventionally, prior to etching, protective layers, such as photoresists, are deposited and developed to act as templates, or protective masks, in order to define structures from a passivation layer, such as a doped silicon dioxide layer, by etching techniques. Wet etch or dry etch techniques may be employed through such protective masks to define semiconductor device structures from doped silicon dioxide passivation layers.

An exemplary wet etch process is disclosed in United States Patent 5,300,463 ("the `463 patent"), issued to David A. Cathey et al. The wet etch process of the `463 patent, which employs hydrofluoric acid (HF) as an etchant, is selective for doped silicon dioxide over undoped silicon dioxide. Despite the selectivity, or specificity, of that technique, it is somewhat undesirable from the standpoint that it suffers from many of the shortcomings that are typically associated with wet etch processes. Specifically, the technique of the '463 patent is an isotropic etch. Consequently, the structures defined thereby may have different dimensions than those of the target area of the etch substrate that is exposed through the protective mask. Moreover, as those of skill in the art are aware, since wet etch techniques are typically isotropic, if the thickness of the film being etched is approximately equivalent to the minimum desired pattern dimension, the undercutting that is typically caused by isotropic etching becomes intolerable. Similarly, with the ever-decreasing size of structures that are carried on the active surfaces of semiconductor devices, etching must be very accurate and maintained within very precise tolerances in order to preserve the alignment of such minute structures and to optimize the electrical characteristics of such structures. Such precision often cannot be obtained when many conventional wet etch processes are used to define structures on semiconductor devices. Thus, the lack of precision and isotropic nature of typical wet etching processes are inconsistent with the overall goal of etch processes in forming structures on state-of-the-art semiconductor devices: reproducing the features defined by the protective mask with a high degree of fidelity.

In contrast, many dry etch techniques, including, without limitation, glow-discharge sputtering, ion milling, reactive ion etching (RIE), reactive ion beam etching (RIBE), and high-density plasma etching, are capable of etching in a substantially anisotropic fashion, meaning that the target area of an etch substrate is etched primarily in a substantially vertical direction relative to the exposed, or active, surface of the etched substrate. Thus, such dry etch techniques are capable of defining structures with substantially upright sidewalls from the etch substrate. Consequently, such dry etch techniques are capable of accurately reproducing the features of a protective mask. Due to ever-decreasing dimensions of structures on semiconductor devices, dry etching is often desirable for defining structures upon semiconductor device active surfaces.

Many techniques that employ plasmas to dry etch silicon dioxide layers, however, lack the specificity of comparable wet etch techniques. Fluorocarbons, such as CF₄ and CHF₃, are typically employed in plasma dry etches of silicon dioxide layers. The radio-frequency (RF) plasmas that are typically utilized with these fluorocarbons generate activated species, such as fluoride ions and fluorine free radicals, which attack silicon dioxide to etch same. These activated fluorine radicals and fluoride ions may also attack other materials, such as silicon and silicon nitride. Consequently, in addition to etching the desired layer, many dry etch techniques that employ plasmas also undesirably etch the etch stop layers and other structures of the semiconductor device that are exposed or which become exposed during the etching process.

Etch stop materials employed in dry etch techniques typically underlie an associated etch substrate and are etched at a lower rate than the associated etch substrate. Since the dry etchant etches the etch stop layer at a slower rate than the outer etch substrate, the etch stop layer acts to protect structures therebeneath from the dry etch process, even as the etch stop itself is being consumed.

Since the gate structures of many semiconductor devices include a silicon nitride (Si₃N₄) cap, selectivity between silicon dioxide (SiO₂) and silicon nitride is desirable in order to etch contacts through passivation layers. Many of the so-called silicon dioxide-selective plasma dry etch techniques, however, have a SiO₂ to Si₃N₄ selectivity ratio, or etch rate of SiO₂ to etch rate of Si₃N₄, of less than about 3: 1.

United States Patent 5,286,344 ("the '344 Patent"), issued to Guy Blalock et al. on February 15, 1994, discloses a dry etch process which has much better selectivity for silicon dioxide over silicon nitride than many other conventional silicon dioxide dry etch techniques. Specifically, CH₂F₂, which is employed as an additive to a primary etchant such as CF₄ or CHF₃, imparts the dry etchant mixture with improved selectivity for silicon dioxide over silicon nitride. The high energy ions that are required to etch both silicon dioxide and silicon nitride act by dissociating a chemical bond at the respective oxide or nitride surface. The dissociation energy that is required to etch silicon nitride is, however, less than that required to etch silicon dioxide. The use of CH₂F₂ in the dry etchant causes polymer deposition on the silicon nitride surface that offsets the dissociation properties of silicon nitride relative to the dissociation properties of silicon dioxide to a greater extent than conventional dry etchants that lack additives such as CH₂F₂. As a result, the etchant of the '344 Patent etches silicon dioxide over an etch stop of silicon nitride with a selectivity of greater than 30:1. As with other conventional silicon dioxide dry etch techniques, however, the only material that is disclosed as a useful etch stop in the `344 Patent is silicon nitride. Thus, the utility of the dry etch process that is disclosed in the '344 Patent is limited to defining semiconductor device structures which include a silicon nitride dielectric layer, such as contacts over silicon nitride-capped gates. Moreover, the relative flow rates of each of the dry etchant components disclosed in the '344 Patent are limited to narrow ranges in order to achieve the desired level of selectivity. Similarly, many other conventional dry etch processes require the use of very specific dry etchant components. Thus, the process windows of many conventional dry etch systems are narrow.

US 6,018,184 describes a semiconductor processing method for making contact openings. It includes depositing several insulative layers and performing an anisotropic etch. US 5,814,563 describes a method of etching a dielectric layer on a substrate with high etching selectivity, low etch rate microloading and high etch rates. Further etching methods are described e.g. in WO 98/49719, EP 0 721 205 A2, US 4,529,476 and JP 61251138.

Although silicon nitride is widely employed as an etch stop material, the use of silicon nitride etch stops is somewhat undesirable from the standpoint that the deposition of silicon nitride upon a semiconductor device active surface by low pressure chemical vapor deposition (LPCVD) processes may also form a thick nitride layer on the back surface of the semiconductor device. Such thick nitride layers must be subsequently removed, which increases fabrication time and costs, as well as the potential for damaging the semiconductor device during the fabrication thereof

Moreover, the fluorine radicals and fluoride ions generated during conventional dry etch processes that employ plasmas non-selectively attack, or etch, both doped and undoped silicon dioxide. Stated another way, such silicon dioxide dry etch techniques are incapable of distinguishing between doped and undoped silicon dioxide. Consequently, when conventional dry etch techniques are employed, the use of alternatives to silicon nitride in state-of-the-art semiconductor devices is restricted.

Accordingly, the inventors have recognized a need for etchants that are specific for silicon dioxide over both undoped silicon dioxide and silicon nitride, as well as a need for a selective doped silicon dioxide dry etch process for which both silicon nitride and undoped silicon dioxide act as etch stops, or for which the use of an etch stop is unnecessary. Etchant mixtures are also needed wherein relative concentrations of each of the components of such etchant mixtures may be varied in order to facilitate the use of such mixtures in a broad range of doped silicon dioxide etching applications.

### DISCLOSURE OF INVENTION

The present invention provides a method for patterning a semiconductor device structure according to claim 1. Preferred embodiments are described in the dependent claims.

The etchants used in the method of the present invention include C₂HₓF_{y}, where x is an integer from three to five, inclusive, y is an integer from one to three, inclusive, and x plus y equals six. Specifically, the C₂HₓF_{y} component of the present invention is selected from the group consisting of C₂H₃F_{3,} C₂H₄F₂, and C₂H₅F. The C₂HₓF_{y} component may be used as either a primary etchant or as a component of an etchant mixture. When employed as a primary etchant, the C₂HₓF_{y} component etches doped silicon dioxide at a slow rate relative to the etch rates of many conventional silicon dioxide dry etch techniques, but selectively etches doped silicon dioxide over undoped silicon dioxide.

When used as an additive to other silicon dioxide etchants, the C₂HₓF_{y} component imparts the etchant mixture with selectivity for doped silicon dioxide over undoped silicon dioxide, while permitting the doped silicon dioxide etch to proceed at a comparable rate relative to many conventional doped silicon dioxide dry etch techniques. The amount of the C₂HₓF_{y} component used in the etchant mixture may be varied, depending upon the particular species of the C₂HₓF_{y} component used, the desired level of doped to undoped silicon dioxide selectivity (i.e., selectivity ratio), the desired level of silicon dioxide to silicon nitride selectivity, the desired etch rate, and other factors.

The dry etch process of the present invention employs an etchant which includes the C₂HₓF_{y} component and is selective for doped silicon dioxide over both undoped silicon dioxide and silicon nitride. Thus, the dry etch process of the present invention may be effectively employed for anisotropically etching a doped silicon dioxide layer down to an underlying etch stop of either undoped silicon dioxide or silicon nitride.

Other features and advantages of the present invention will become apparent to those of ordinary skill in the relevant art through a consideration of the ensuing description, the accompanying drawings, and the appended claims.

### BRIEF DESCRIPTION OF THE DRAWINGS

FIGs. 1 through 4 are cross-sectional schematic representations that illustrate a process useful for understanding the present invention and an exemplary structure that may be formed thereby; and
FIGs. 5 through 8 are cross-sectional schematic representations that illustrate use of the process of the present invention on a semiconductor device structure and an example of the resulting structure.

### BEST MODE OR MODES FOR CARRYING OUT THE INVENTION

The present invention uses an etchant that is selective for doped silicon dioxide over both undoped silicon dioxide and silicon nitride. As those of skill in the art are aware, "doped" silicon dioxide typically includes a dopant such as boron or phosphorus, whereas undoped silicon dioxide is substantially free of dopants and other impurities. Exemplary types of doped silicon dioxide include, without limitation, borosilicate glass (BSG), phosphosilicate glass (PSG), and borophosphosilicate glass (BPSG). The present invention includes a dry etch process which utilizes the etchant.

The doped silicon dioxide etchant, which is also referred to herein as an etchant for simplicity, includes an ethane component of the general formula C₂HₓF_{y}, which is also referred to as the C₂HₓF_{y} component or C₂HₓF_{y} for simplicity, where x is an integer from three to five, inclusive, y is an integer from one to three, inclusive, and x plus y equals six. Specifically, the C₂HₓF_{y} component used in the method of the present invention is selected from the group consisting of C₂H₃F₃, C₂H₄F₂, and C₂H₅F. The doped silicon dioxide etchant may also include combinations, of various types of C₂HₓF_{y}.

As the C₂HₓF_{y} component of a doped silicon dioxide etchant is RF activated, the hydrogen ions and activated hydrogen species react with the fluorine-containing ions and activated fluorine-containing species (e.g., F* and CF*), removing the activated fluorine-containing species from the surface of the wafer prior to the occurrence of any substantial amount of etching of an etch stop layer of either undoped silicon dioxide or silicon nitride. The hydrogen content of the C₂HₓF_{y} additives imparts etchants including the same with specificity for doped silicon dioxide over undoped silicon dioxide.

In a first embodiment of the doped silicon dioxide etch method of the present invention, the C₂HₓF_{y} component is a primary etchant. When used as the primary etchant, the C₂HₓF_{y} component is selective for doped silicon dioxide over undoped silicon dioxide. Stated another way, the C₂HₓF_{y} component etches doped silicon dioxide at a higher rate than it etches undoped silicon dioxide. As the primary etchant, the C₂HₓF_{y} component etches doped silicon dioxide at a relatively slow rate compared to the etch rates of many conventional silicon dioxide dry etchants. Thus, additives which will increase the etch rate may be used in combination with the C₂HₓF_{y} component. Such additives include, but are not limited to, CF₄, CHF₃, and other halogenated carbon materials which have been used as primary etchants in conventional doped silicon dioxide dry etch techniques.

Similarly, additives that increase an etchant's selectivity for silicon dioxide over silicon nitride (i.e., reduce the rate at which silicon nitride is etched) may also be used as additives to etchants which include the C₂HₓF_{y} component as the primary etchant. The '334 Patent discloses some exemplary additives that may enhance the selectivity of C₂HₓF_{y} in this manner. The additives of the '344 Patent are fluorocarbons in which the number of hydrogen atoms is equal to or greater than the number of fluorine atoms, such as CH₂F₂ and CH₃F.

Other additives may also be used with silicon dioxide etchants that include the C₂HₓF_{y} component as the primary etchant in order to alter other characteristics of such etchants, including, without limitation, the selectivity of such etchants for doped silicon dioxide over undoped silicon dioxide and the selectivity for certain types of doped silicon dioxide over other types of doped silicon dioxide.

In another embodiment of the doped silicon dioxide etch method of the present invention the C₂HₓF_{y} component is employed as an additive to one or more primary etchants. The C₂HₓF_{y} component may be used as an additive to etchants which include a fluorocarbon primary etchant, such as CF₄, CHF₃, or other fluorocarbons that etch silicon dioxide at a higher rate than they etch silicon nitride (i.e., are selective for silicon dioxide over silicon nitride). According to the `344 Patent, CF₄ and CHF₃ are exemplary primary etchants with which the C₂HₓF_{y} component may be utilized as an additive.

When used as an additive to a silicon dioxide etchant, such as CF₄ or CHF₃, the C₂HₓF_{y} component imparts the silicon dioxide etchant with selectivity for doped silicon dioxide over undoped silicon dioxide while permitting the doped silicon dioxide etch to proceed at a substantially normal rate. The amount of the C₂HₓF_{y} component that is used in an etchant mixture, relative to the amounts of other etchants and any carrier gas, may be varied in order to tailor the characteristics of the etchant mixture and to achieve the desired etching results. The various characteristics of the etchant mixture that may be varied by altering the concentration of the C₂HₓF_{y} component in the mixture include, but are not limited to, selectivity for doped silicon dioxide over undoped silicon dioxide, selectivity for silicon dioxide over silicon nitride, and the doped silicon dioxide etch rate.

An exemplary dry etchant useful for understanding the present invention that is selective for doped silicon dioxide over both undoped silicon dioxide and silicon nitride includes about 40% of the additive C₂H₂F₄ (i.e., a C₂HₓF_{y} component), about 30% of the primary etchant CHF₃, and about 30% of CH₂F₂, an additive which improves the selectivity of the primary etchants for silicon dioxide over silicon nitride, each of the percentages based on the relative flow rates of each gas into the etcher.

Alternatively, the amounts of the C₂HₓF_{y} component may be varied considerably. using etchants that include any amount of an additive of the general formula C₂HₓF_{y}, where x is an integer from three to five, inclusive, where y is an integer from one to three, inclusive, and where x plus y equals six, is within the scope of the present invention. Exemplary etchants may include five percent, ten percent, twenty percent, sixty-five percent, or ninety percent of the C₂HₓF_{y} additive or any combination of C₂HₓF_{y} additives.

Similarly, it is also foreseen that the C₂HₓF_{y} component may be employed as an additive to silicon dioxide dry etchant mixtures that include other components. For example, the C₂HₓF_{y} component could be used along with an etchant that includes either CF₄ or CHF₃, or both of them as primary etchants and a carrier gas, such as argon or nitrogen. Alternatively, the C₂HₓF_{y}-containing dry etchant may include one or more other additives that alter the various characteristics of the dry etchant, such as the etch rate, the degree of selectivity, and the type of selectivity. For example, as disclosed in the '344 Patent, the use of CH₂F₂ as an additive enhances the selectivity of the dry etchant for silicon dioxide over silicon nitride. Combinations of the additives of the general formula C₂HₓF_{y} may also be employed as components in a doped silicon dioxide dry etchant.

A preferred embodiment of the dry etch process of the present invention is selective for doped silicon dioxide over both undoped silicon dioxide and silicon nitride. The dry etch process includes using the etchant to etch a doped silicon dioxide layer down to a structure or layer of either undoped silicon dioxide or silicon nitride, which structure or layer may form or be part of an etch stop.

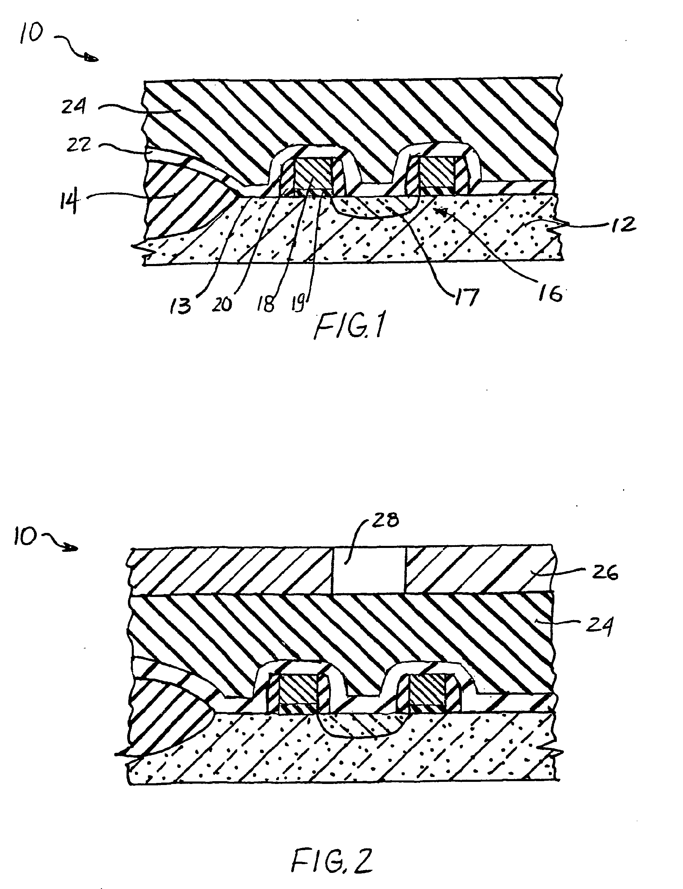

Referring to FIGs. 1 to 4, an etch process useful for understanding the present invention, is illustrated. FIG. 1 depicts an exemplary multi-layer structure 10, which is also referred to as a semiconductor device structure, that may be fabricated, at least in part, in accordance with the process useful for understanding the present invention. Multi-layer structure 10 includes a semiconductor substrate 12 (e.g., a silicon wafer, silicon-on-insulator (SOI), silicon-on-sapphire (SOS), silicon-on-glass (SOG), etc.), a field oxide layer 14 disposed on an active surface 13 of the semiconductor substrate and an active device region 16. A diffusion region 17, which is also referred to herein as a contact, that includes conductively doped semiconductor material (e.g., silicon) is formed in active device region 16 and is continuous with active surface 13. Conductive lines 18, which are formed from a conductive material such as metal or polysilicon, are disposed on active surface 13 in active device region 16, electrically separated from active surface 13 by way of gate oxides 19, and are positioned laterally adjacent diffusion region 17. Sidewall spacers 20, which are positioned on each side of the conductive lines 18, and intermediate structural layer or insulative caps 22 disposed over conductive lines 18, electrically insulate conductive lines 18. Sidewall spacers 20 and caps 22 may be fabricated from silicon nitride or undoped silicon dioxide. Multi-layer structure 10 also includes a passivation layer 24 disposed over each of the foregoing elements. Passivation layer 24 is fabricated from doped silicon dioxide (e.g., BPSG, PSG or BSG).

FIG. 2 depicts masking of multi-layer structure 10 prior to defining a structure through passivation layer 24. A mask 26, which is also referred to as a protective layer, is layered and patterned over passivation layer 24. Mask 26 may be formed from a material such as a photoresist or other photoimageable material. Exemplary positive photoresists that are useful as mask 26 may include a novolac resin, a diazonaphthaquinone, and a solvent, such as n-butyl acetate or xylene. Exemplary negative photoresists that are useful as mask 26 may include a cyclized synthetic rubber resin, bis-arylazide, and an aromatic solvent. Such a mask 26 may be applied to, or coated onto, multi-layer structure 10 and patterned by techniques that are known to those in the art, such as spin coating and photomask processing and patterning techniques. Alternatively, mask 26 may comprise an aerosol spray pattern of electrostatically chargeable hardenable liquid material, such as a polymer, which is not etched or is etched at a much slower rate than the underlying passivation layer 24. An exemplary method for spray-patterning such electrostatically chargeable hardenable liquid materials is described in United States Patent 5,695,658 (the "'658 Patent"), issued to James J. Alwan on December 9, 1997. Both photoresist materials (positive and negative) and non-photoimageable materials may be employed as mask 26 in accordance with the '658 Patent. The utilization of masks 26 that comprise other non-photoimageable materials and the processes for applying and patterning them are also within the scope of the method of the present invention. The patterning of mask 26 defines openings 28, which are also referred to as apertures or contact apertures, therethrough, through which predetermined structures will be defined in the underlying passivation layer 24 during a subsequent etch step. Mask 26 comprises a material that is resistant to the etchant (i.e., the etchant does not etch mask 26 or etches the mask at a relatively slow rate compared to the rate at which the etch substrate is etched). Thus, the areas of passivation layer 24 that underlie mask 26 are protected from the etchant during the subsequent etch step.

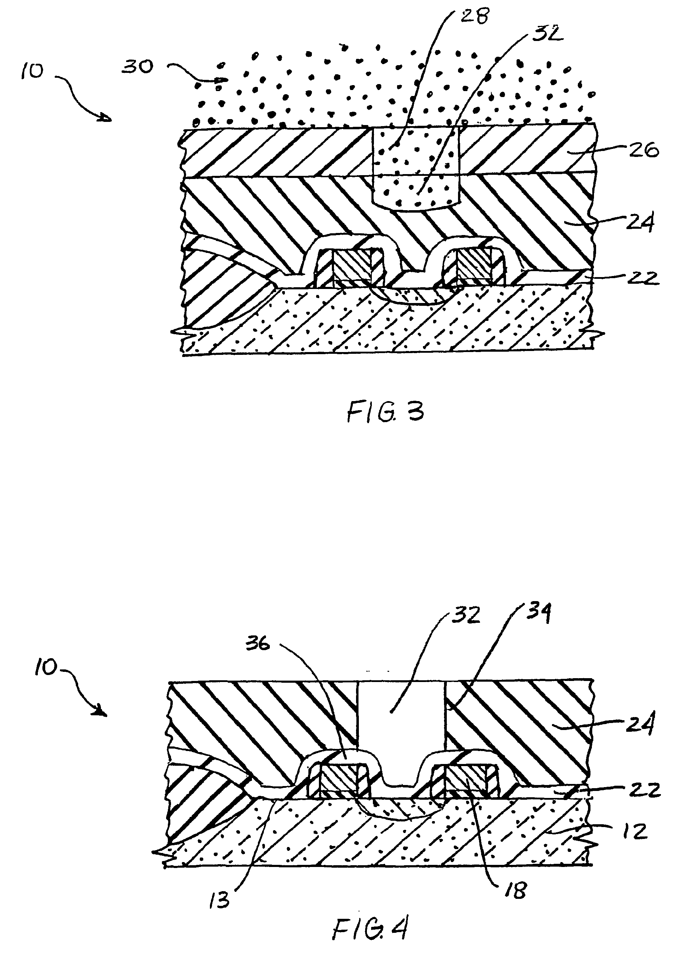

Turning now to FIG. 3, an etch is depicted, wherein an activated etchant 30, which is introduced into an etch chamber (not shown) either with or without a carrier gas, attacks the areas of passivation layer 24 that are exposed through openings 28 of mask 26. Dry etch processes that are known to those of skill in the art, including, without limitation, high-density plasma etching, reactive ion etching (RIE), magnetic ion etching (MIE), magnetically enhanced reactive ion etching (MERIE), plasma etching (PE), point plasma etching, plasma enhanced reactive ion etching (PERIE), and electron cyclotron resonance (ECR), may be employed. When activated, etchant 30, which comprises a C₂HₓF_{y}-containing etchant, etches a contact opening 32, or an aperture, through passivation layer 24 in a substantially vertical fashion until intermediate structural layer 22 is exposed. Intermediate structural layer 22, which is fabricated from either undoped silicon dioxide or silicon nitride, acts as an etch stop layer. Thus, etchant 30 etches intermediate structural layer 22 at a slower rate than the rate at which passivation layer 24 is etched. After the exposed areas of passivation layer 24 have been etched, mask 26 may be removed by processes that are known in the art, such as washing or etching (wet or dry) techniques.

FIG. 4 illustrates a contact opening 32 or aperture that has been formed through passivation layer 24 by the etch process. Contact opening 32 includes sidewalls 34 that are substantially vertical relative to active surface 13 of semiconductor substrate 12 or oriented substantially perpendicular relative to a plane of semiconductor substrate 12. Contact openings 32 of the multi-layer structure 10 expose at least a portion of the intermediate structural layer 22 that lies above each of conductive lines 18. Intermediate structural layer 22 defines a cap 36 over each conductive line 18. Thus, cap 36 may be fabricated from either undoped silicon dioxide or silicon nitride.

Intermediate structural layer 22 may then be removed from above diffusion region 17 to expose same by known processes, such as by masking multi-layer structure 10 and patterning intermediate structural layer 22 with wet or dry etchants, which preferably etch the material of intermediate structural layer 22 with selectivity over the material of diffusion region 17. Further processing of multi-layer structure 10 may then be conducted as known in the art (e.g., to form a conductive structure in contact with diffusion region 17).

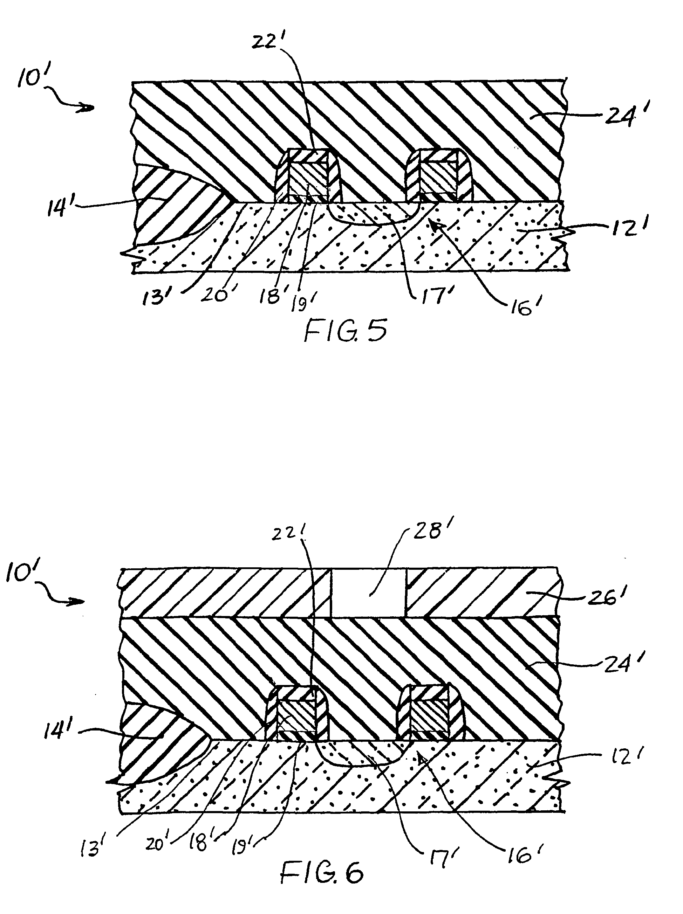

An example of the process of the present invention is illustrated in FIGs. 5 to 8. FIG. 5 illustrates an exemplary multi-layer structure 10' with which the process of the present invention may be employed. Multi-layer structure 10', which is also referred to herein as a semiconductor device structure, includes a semiconductor substrate 12', a field oxide layer 14' formed on an active surface 13' of semiconductor substrate 12', and an active device region 16' adjacent field oxide layer 14'. A conductively doped diffusion region 17', which is also referred to herein as a contact, is formed in active device region 16' of semiconductor substrate 12' adjacent active surface 13'. Conductive lines 18', which may be formed from polysilicon or other electrically conductive materials, as known in the art, overly active device region 16' on active surface 13', are separated therefrom by way of gate oxide 19', and are positioned laterally adjacent diffusion region 17'. Conductive lines 18' are insulated by sidewall spacers 20' positioned adjacent each side thereof, as well as a cap 22' covering the top of each conductive line 18'. Sidewall spacers 20' and caps 22' are fabricated from undoped silicon dioxide. Multi-layer structure 10' also includes a passivation layer 24', formed from doped silicon dioxide (e.g., BPSG, PSG, or BSG), over diffusion region 17', conductive lines 18', sidewall spacers 20', and caps 22'.

In FIG. 6, multi-layer structure 10' is depicted as including a mask 26', or protective layer, formed over passivation layer 24'. Mask 26' may be formed by the same processes disclosed above with reference to the fabrication of mask 26 depicted in FIG. 2. Mask 26' includes openings 28', which are also referred to as apertures or contact apertures, formed therethrough, through which predetermined structures will be defined in the underlying passivation layer 24' during a subsequent etch step. Mask 26' comprises a material that is resistant to the etchant of the present invention (i.e., the etchant does not etch mask 26' or etches mask 26' at a relatively slow rate compared to the rate at which passivation layer 24' is etched). The areas of passivation layer 24' that underlie mask 26' are protected from the etchant during the subsequent etch step.

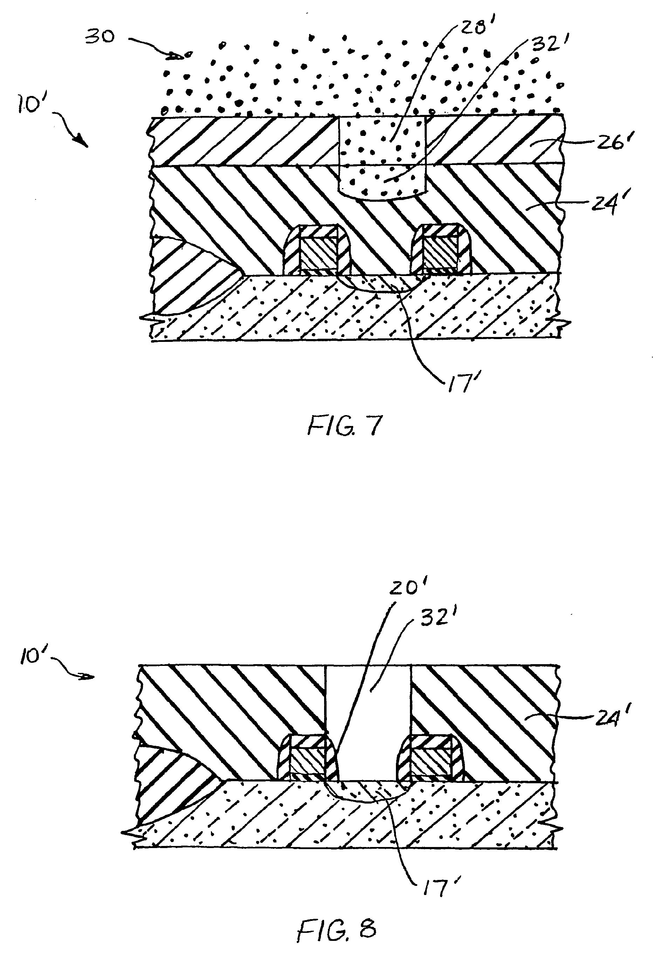

The removal of material of passivation layer 24' through mask 26' is depicted in FIG. 7. An etchant 30, which is introduced into an etch chamber (not shown) either with or without a carrier gas, attacks the areas of passivation layer 24' that are exposed through openings 28' of mask 26'. Known dry etch processes, such as those listed previously herein with reference to the use of etchant 30 as depicted in FIG. 3, may be used with the etchant in the process of the present invention. Etchant 30, which comprises a C₂H₃F_{3,} C₂H₄F₂ or C₂H₅F-containing etchant of the method of the present invention, etches an aperture 32' through passivation layer 24' in a substantially vertical fashion until diffusion region 17' is exposed, as shown in FIG. 8. As passivation layer 24' is etched through aperture 28' down to diffusion region 17', sidewall spacers 20', which are formed of silicon dioxide, are exposed within contact aperture 32' without being substantially etched, or are etched at a slower rate than the rate at which passivation layer 24' is etched. After the exposed areas of passivation layer 24' have been etched, mask 26' may be removed by processes that are known in the art, such as washing or etching techniques. Etchant 30 also preferably etches doped silicon dioxide with selectivity over conductively doped silicon or another material of diffusion region 17'.

Further processing of multi-layer structure 10' may then be conducted as known in the art (e.g.; to form a conductive structure in contact with diffusion region 17').

Although the foregoing description contains many specifics, these should not be construed as limiting the scope of the present invention, but merely as providing illustrations of some of the presently preferred embodiments. Similarly, other embodiments of the invention may be devised which do not depart from the scope of the present invention.

## Claims

1. A method for patterning a semiconductor device structure (10') including doped silicon dioxide (24') and undoped silicon dioxide (20'), comprising:
disposing a mask material over the doped silicon dioxide (24');
patterning the mask material to expose selected regions of the doped silicon dioxide; and
dry etching the exposed selected regions with an etchant comprising C₂HₓF_{y}, where x is an integer from three to five, inclusive, where y is an integer from one to three, inclusive, and where x plus y equals six,
the dry etching of the doped silicon dioxide (24') being selective over dry etching of undoped silicon dioxide (20') and being effected at least until the doped silicon dioxide (24') is removed to thereby expose the semiconductor substrate (12') and the undoped silicon dioxide (20') of the semiconductor device structure (10').

2. The method of claim 1, wherein disposing the mask material comprises disposing a photoimageable material.

3. The method of claim 2, wherein patterning comprises photolithography.

4. The method of claim 1, wherein disposing the mask material comprises disposing a non-photoimageable material.

5. The method of claim 1, wherein dry etching is effected using a technique selected from the group comprising reactive ion etching, plasma etching, high-density plasma etching, point plasma etching, magnetic ion etching, magnetically enhanced reactive ion etching, plasma enhanced reactive ion etching, and electron cyclotron resonance.

6. The method of claim 1, wherein dry etching comprises reactive ion etching.

7. The method of claim 1, wherein dry etching comprises high plasma etching.

## Patentansprüche

1. Eine Methode für die Strukturierung einer Halbleiter-Bauelementstruktur (10'), beinhaltend dotiertes Siliziumdioxid (24') und undotiertes Siliziumdioxid (20'), umfassend:
Ablagern eines Maskenmaterials über dem dotierten Siliziumdioxid (24');
Strukturieren des Maskenmaterials, um ausgewählte Bereiche des dotierten Siliziumdioxids zu exponieren; und
Trockenätzen der exponierten ausgewählten Bereiche mit einem Ätzmittel umfassend C₂HₓFy, wo x eine ganze Zahl von drei bis fünf ist, eingeschlossen, wo y eine ganze Zahl von eins bis drei ist, eingeschlossen, und wo x plus y sechs ergibt,
das Trockenätzen des dotierten Siliziumdioxids (24') selektiv über Trockenätzen des nicht dotierten Siliziumdioxids (20') ist und zumindest ausgeführt wird bis das dotierte Siliziumdioxid (24') abgetragen ist, um so das Halbleitersubstrat (12') und das nicht dotierte Siliziumdioxid (20') der Halbleiter-Bauelementstruktur (10') zu exponieren.

2. Die Methode nach Anspruch 1, worin Ablagern des Maskenmaterials Ablagern eines belichtbaren Materials umfasst.

3. Die Methode nach Anspruch 2, worin Strukturieren Fotolithographie umfasst.

4. Die Methode nach Anspruch 1, worin Ablagern des Maskenmaterials Ablagern eines nicht belichtbaren Materials umfasst.

5. Die Methode nach Anspruch 1, worin Trockenätzen durch Verwenden einer Technik, ausgewählt aus der Gruppe umfassend Reaktives Ionenätzen, Plasmaätzen, Ätzen mit hochdichtem Plasma, Punkt-Plasmaätzen, Magnetisches Ionenätzen, magnetisch gefördertes Reaktives Ionenätzen, plasmagefördertes Reaktives Ionenätzen und Elektronen-Zyklotronresonanz, erreicht wird.

6. Die Methode nach Anspruch 1, worin Trockenätzen Reaktives Ionenätzen umfasst.

7. Die Methode nach Anspruch 1, worin Trockenätzen Ätzen mit hohem Plasma umfasst.

## Revendications

1. Un procédé pour former un motif sur une structure de composant semi-conducteur (10') comprenant du dioxyde de silicium dopé (24') et du dioxyde de silicium non dopé (20'), comprenant les étapes consistant à :
- mettre en place un matériau de masque au-dessus du dioxyde de silicium dopé (24') ;
- former un motif sur le matériau de masque pour exposer des régions choisies du dioxyde de silicium dopé ; et
- graver à sec les régions choisies exposées avec un agent de gravure comprenant C₂HₓF_{y}, où x est un entier compris entre trois et cinq, inclus, où y est un entier compris entre un et trois, inclus, et où x plus y vaut six,
la gravure à sec du dioxyde de silicium dopé (24') étant sélective par rapport à la gravure à sec du dioxyde de silicium non dopé (20') et étant effectuée au moins jusqu'à ce que le dioxyde de silicium dopé (24') soit éliminé, de manière à ainsi exposer le substrat semi-conducteur (12') et le dioxyde de silicium non dopé (20') de la structure de composant semi-conducteur (10').

2. Le procédé de la revendication 1, dans lequel l'étape consistant à mettre en place le matériau de masque comprend la mise en place d'un matériau photoimageable.

3. Le procédé de 1a revendication 2, dans lequel la formation du motif comprend une photolithographie.

4. Le procédé de la revendication 1, dans lequel la mise en place du matériau de masque comprend la mise en place d'un matériau non photoimageable.

5. Le procédé de la revendication 1, dans lequel la gravure à sec est effectuée par utilisation d'une technique choisie dans le groupe comprenant la gravure ionique réactive, la gravure par plasma, la gravure par plasma à haute densité, la gravure par plasma ponctuel, la gravure ionique magnétique, la gravure ionique réactive à renforcement magnétique, la gravure ionique réactive à renforcement par plasma, et la résonance électronique par cyclotron.

6. Le procédé de la revendication 1, dans lequel la gravure à sec comprend une gravure ionique réactive.

7. Le procédé de la revendication 1, dans lequel la gravure à sec comprend une gravure par plasma à haute densité.
